# EUROPÄISCHE PATENTSCHRIFT

(11) **EP 2 959 032 B1**
(45) Veröffentlichungstag und Bekanntmachung des Hinweises auf die Patenterteilung: **13.09.2017**
(21) Anmeldenummer: 14705280.7
(22) Anmeldetag: 10.02.2014
(51) Int. Cl.: C23C 16/00, C23C 16/02, C23C 16/26, C23C 16/455

(54) **DEKORATIVE, TIEFSCHWARZE BESCHICHTUNG**
DECORATIVE DEEP-BLACK LAYER
COUCHE DÉCORATIVE PRÉSENTANT UN NOIR PROFOND

(30) Priorität: 21.02.2013 DE 102013002911
(43) Veröffentlichungstag der Anmeldung: 30.12.2015
(73) Patentinhaber: Oerlikon Surface Solutions AG, Pfäffikon, 8808 Pfäffikon (CH)
(72) Erfinder: GUIMOND, Sebastien, CH-9000 St Gallen (CH); WURZER, Manfred, CH-9300 Wittenbach (CH); WIDOWITZ, Franz, A-6800 Feldkirch (AT)
(74) Vertreter: Misselhorn, Hein-Martin
(86) Internationale Anmeldenummer: PCT/EP2014/000355
(87) Internationale Veröffentlichungsnummer: WO 2014/127890

(56) Entgegenhaltungen:
- WO-A1-00/47290
- US-A- 5 900 289
- ZHANG G F ET AL: "Influence of deposition parameters on the refractive index and growth rate of diamond-like carbon films", SURFACE AND COATINGS TECHNOLOGY, ELSEVIER, AMSTERDAM, NL, Bd. 64, Nr. 2, 1. Mai 1994 (1994-05-01), Seiten 127-130, XP026502514, ISSN: 0257-8972, DOI: 10.1016/S0257-8972(09)90013-5 [gefunden am 1994-05-01]
- STUBER M ET AL: "Graded layer design for stress-reduced and strongly adherent superhard amorphous carbon films", SURFACE AND COATINGS TECHNOLOGY, ELSEVIER, AMSTERDAM, NL, Bd. 116-119, 1. September 1999 (1999-09-01), Seiten 591-598, XP027346036, ISSN: 0257-8972 [gefunden am 1999-09-01]

## Beschreibung

Die vorliegende Erfindung bezieht sich auf eine Methode zu Herstellung einer Verschleissschutzschicht für dekorative Anwendungen mit tiefschwarzem Aussehen. Es besteht ein grosses Bedürfnis nach schwarz erscheinenden Oberflächen, so zum Beispiel im Bereich von Konsumartikeln wie Uhrengehäuse, Mobiltelefone oder auch Stossstangen an Kraftfahrzeugen. Bei solchen Anwendungen spielt jedoch nicht nur das äussere, vorzugsweise tiefschwarze Erscheinungsbild eine Rolle, sondern auch die Beständigkeit gegenüber äusseren mechanische Einwirkungen. Insbesondere sollte die Oberfläche kratzfest sein.

In der deutschen Anmeldung DE3639469 wird eine Hartstoffschicht mit dekorativem schwarzen Erscheinungsbild beschrieben, die gleichzeitig eine hohe Verschleissbeständigkeit aufweist. Diese Hartstoffschicht umfasst eine erste Schicht bestehend aus einem Element der Gruppen IVa, Va des periodischen Systems der Elemente, eine zweite Schicht, welche ein Nitrid dieses Elementes der ersten Schicht umfasst, eine dritte Schicht, welche ein Karbid des Elementes umfasst und eine Deckschicht bestehend aus einer harten Kohlenstoffschicht, wobei Karbidkristallite desselben Elementes in diese Deckschicht eingebettet sind.

Es ist ausserdem bekannt, DLC-Schichten einzusetzen. Diese haben ein schwarzes Erscheinungsbild und einen hohen Härtegrad. Allerdings besitzen herkömmliche DLC-Schichten Neutralgrauwerte (L* =lightness), welche im Bereich über 40 liegen. Hierbei und im Rahmen der vorliegenden Beschreibung wird der CIE 1976 L*a*b* Farbraum auf der Basis einer D65 Standardbeleuchtung und einer d/8° (=diffuse Beleuchtung und Messung unter 8°) zugrunde gelegt. Als tiefschwarze Oberflächen werden im Zusammenhang mit der vorliegenden Beschreibung Oberflächen bezeichnet, die Neutralgrauwerte L*=<40 aufweisen.

Der schwarze Eindruck der DLC-Schichten erfolgt durch ihre gute Absorptionsfähigkeit. Dies ist eine Folge des relativ hohen Absorptionskoeffizienten des Materials. Dieser Absorptionskoeffizient geht allerdings mit einem hohen Brechungsindex von zwischen 2.1 und 2.3 einher. Dies hat zur Folge, dass beim Auftreffen des Lichtes auf die Oberfläche der DLC-Beschichtung aufgrund des grossen Sprungs im Brechungsindex beim Übergang von Luft (n=1) in die Schicht ein signifikanter Teil des Lichtes reflektiert wird und so zu einem hohen L* Wert führt. Es wäre nun möglich, auf dieser Oberfläche eine optische Antireflexionsschicht vorzusehen. Allerdings basieren solche Schichten auf dem Prinzip der Interferenz. Deren Reflexionsverhalten ist somit einerseits wellenlängenabhängig und andererseits auch abhängig vom Einfallswinkel. Es kommt hinzu, dass das Reflexionsverhalten solcher Schichten stark von der realisierten Schichtdicke abhängig ist. Dies kann vor allem bei Geometrien der zu beschichtenden Bauteite, welche nicht planar sind,zu erheblichen Problemen führen.

Es besteht daher ein Bedürfnis nach einer harten Oberflächenbeschichtung, welche zu einem tiefschwarzen optischen Eindruck führt, der vorzugsweise unabhängig vom Betrachtungswinkel bestehen bleibt.

Es ist daher die Aufgabe der vorliegenden Erfindung, eine harte Oberflächenbeschichtung anzugeben, welche zu einem tiefschwarzen optischen Eindruck führt, der vorzugsweise unabhängig vom Betrachtungswinkel bestehen bleibt.

Das entsprechend der vorliegenden Erfindung hergestellte Schichtsystem zeigt einen niedrigeren L* Wert als eine herkömmliche DLC-Schicht. Dies wird dadurch erreicht, dass auf eine DLC-Schicht eine Gradientenschicht mit abnehmender Dichte und dadurch mit abnehmendem Brechungsindex realisiert wird. Bei genügender Dicke der Gradientenschicht wird hierdurch eine Verminderung der Fresnelreflexion an der Oberfläche erreicht. Beispielsweise beträgt die Reflexion einer herkömmlichen DLC-Oberfläche mit n_{DLC}=2.3 bei senkrechtem Lichteinfall ca 16%. Dies führt zu einem L*-Wert von ca. 47. Demgegenüber beträgt die Reflexion einer Oberfläche mit n=1.7 bei senkrechtem Lichteinfall lediglich 7%. Aufgrund des in der Gradientenschicht realisierten ansteigenden Brechungsindexes kommt es innerhalb der Gradientenschicht und beim Übergang zur DLC-Schicht im Wesentlichen nicht mehr zur Fresnelreflexion. Damit liegt der L* bei lediglich 32.

Dabei ist klar, dass aufgrund der geringeren und abnehmenden Dichte der Gradientenschicht dies zu einer Reduktion der Gesamthärte der Schicht führt. In einer bevorzugten Ausführungsform wird der Gradient so realisiert, dass die Gesamthärte der Schicht nicht geringer als 15 GPa ist.

Gemäss einer weiteren bevorzugten Ausführungsform der vorliegenden Erfindung hat die DLC-Schicht einen Brechungsindex zwischen 2 und 3 und/oder einen Neutralgrauwert L* zwischen 40 und 60, mehr bevorzugt zwischen 45 und 55.

Gemäss einer weiteren bevorzugten Ausführungsform der vorliegenden Erfindung hat die DLC-Schicht eine Härte, welche nicht geringer als 1500HV oder 15 GPa ist, bevorzugterweise nicht geringer als 18 GPa ist und noch bevorzugter nicht geringer als 20 GPa. ist.

Gemäss einer weiteren bevorzugten Ausführungsform der vorliegenden Erfindung gibt es innerhalb der Gradientenschichtdicke keinen Bereich,der eine geringere Härte als 600 HV oder 6 GPa aufweist, vorzugsweise nicht geringer als 8 GPa.

Gemäss einer weiteren Ausführungsform der vorliegenden Erfindung ist die Dicke der DLC-Schicht nicht geringer als 0.5µm.

Gemäss einer weiteren Ausführungsform der vorliegenden Erfindung beträgt die Dicke der Gradientenschicht nicht weniger als 300 nm.

Eine Beschichtung gemäss der vorliegenden Erfindung kann beispielsweise mittels Plasma-unterstützten CVD Prozessen oder PVD - Prozessen oder einer Kombination aus beidem hergestellt werden.

Eine bevorzugte Ausführungsform der vorliegenden Erfindung zur Herstellung der Schichten umfasst einen kombinierten plasmaunterstützten CVD und Zerstäubungsprozess.

Die Beschichtung entsprechend der vorliegenden Erfindung hat unter anderem folgende Vorteile:
Die DLC-Schicht bleibt hart genug,um Verschleissschutz zu gewährleisten. Falls die etwas weichere Gradientenschicht Kratzer bekommt, bleibt wenigstens die darunter liegende DLC-Schicht intakt und da diese auch schwarz ist, wird der Kratzer kaum auffallen.

Auf Substraten mit erhöhter Rauigkeit kann es sogar zu einer Erhöhung der Verschleissbeständigkeit der Gradientenschicht kommen, da die Bereiche zwischen den Substratspitzen geschützt sind.

Dadurch, dass der Effekt der Reflexminderung nicht auf Interferenzeffekte zurückgeht, sind die Schichtdickenabhängigkeit und die Winkelabhängigkeit der Reflexion stark vermindert.

Zur Herstellung der Gradientenschicht können herkömmliche Anlagen für die Herstellung der DLC-Schicht herangezogen werden. Es wird keine zusätzliche Ausrüstung oder zusätzliche Gase benötigt.

Die Erfindung wird nun anhand einer Prozessbeschreibung im Detail und beispielhaft erläutert :

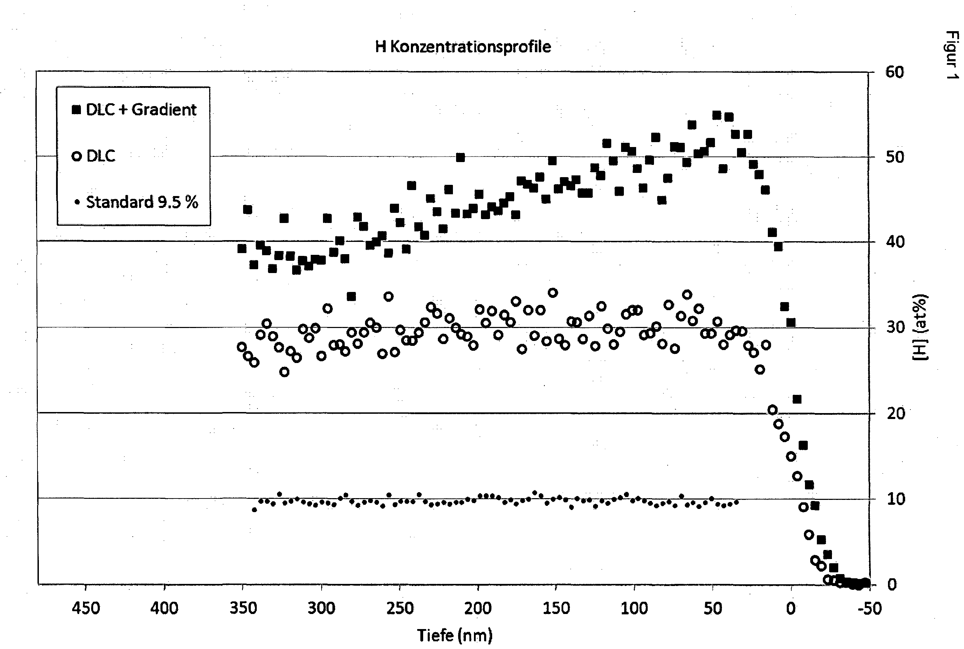

Figur 1 zeigt die Wasserstoffkonzentration für verschiedene DLC Proben im Vergleich zu einer Referenz.

Die Substrate wurden in einer Vakuumkammer mittels einer plasmaunterstützten CVD Methode hergestellt, wobei eine Kombination aus Acetylen und Argon als Prozessgas verwendet wird. Das Prozessgas wurde in der Kammer mittels eines Plasmas ionisiert, welches über eine Niedervoltbogenentladung erzeugt wurde. Zusätzlich wurde während des Beschichtungsprozesses ein Substratbias an die Substrate angelegt.

Zur Beschichtung der DLC-Schicht wurde der Substratbias auf einem konstanten Wert von 900 V gehalten. Die DLC-Beschichtung nahm 80 Minuten in Anspruch. Zur Beschichtung der Gradientenschicht wurde der Substratbias kontinuierlich von 900 V auf 50 V reduziert. Nach Ablauf von 40 Minuten war ein Substratbias von 50 V erreicht. Abgesehen vom Substratbias wurden die anderen Beschichtungsparameter während der gesamten Beschichtung konstant gehalten. Vorzugsweise wird jedoch der Niedervoltbogen-Entladungsstrom kontinuierlich erhöht um der mit der Reduktion des Substratbias einhergehenden Abnahme des Substratstroms entgegen zu wirken. Durch diese kontinuierliche Reduktion des Substratbias erfolgte eine kontinuierliche Reduktion der Schichtdichte, die wiederum eine Reduktion des Brechungsindexes zur Folge hatte.

Im Ergebnis war die Gradientenschicht 0.7 µm dick. Die für das Gesamtsystem (DLC-Schicht und Gradientenschicht) auf einem Fischerscope mit 10mN Last gemessene Härte betrug 18GPa. Der gemessene Wert L* betrug 35. Dies würde einem Brechungsindex an der Oberfläche von n = 1.85 entsprechen. Zusätzlich wurde der grün-rot Faktor a* und der gelb-blau Faktor b* entsprechend der Definition des Lab Farbraums gemessen. Für a* wurde ein Wert von -0.5±1 und für b* wurde ein Wert von 1±1 gemessen. Das Schichtsystem zeigte eine exzellente Verschleissbeständigkeit.

Der Brechungsindex der Gradientenschicht kann nicht beliebig reduziert werden, weil dies unmittelbar Einfluss auf die Gesamthärte der Schicht hat. Dadurch allerdings, dass der reflexmindernde Effekt der Gradientenschicht nicht auf Interferenzeffekten beruht, ist es möglich, wenn einmal der niedrigste zu realisierende Brechungsindex erreicht ist, die Gradientenschicht mit diesem Brechungsindex weiter zu beschichten. Im vorangehenden Beispiel könnte man zum Beispiel bei Erreichen eines Substratbias von 50 V für 20 Minuten unter Beibehaltung dieses Biaswertes weiterbeschichten, ohne die Reflexion wieder zu erhöhen.

Das in der Beschreibung aufgezeigte Beispiel bezog sich auf eine Gradientenschicht, welche in ihrer Zusammensetzung im Wesentlichen der DLC-Schicht entspricht. Es ist jedoch auch möglich, eine geringere optische Dichte dadurch zu erzielen, dass nach Aufbringen der DLC-Schicht im weiteren Beschichtungsverlauf und mit zunehmender Konzentration ein weiteres chemisches Element oder mehrere weitere chemische Elemente beigefügt werden, während gleichzeitig die Konzentration des Kohlenstoffs abnimmt. Im Extremfall kann der Kohlenstoffgehalt an der Oberfläche Null betragen. Beispielhaft sei hier Silizium bzw. SiOx erwähnt mit x>=0. Wird zum Beispiel so vorgegangen, dass es, ausgehend von der DLC-Schicht, zu einer Zunahme des SiOx Gehaltes kommt, eventuell auch mit Variation von x, beispielsweise von x=0 an der "Grenzfläche" zur DLC-Schicht und x=2 an der Oberfläche, so kann an der Oberfläche eine SiO2 Schicht realisiert werden, welche einen Brechungsindex von 1.5 aufweist. Für senkrecht einfallendes Licht werden in diesem Fall lediglich noch 4% reflektiert.

Ein Tiefenprofil der Wasserstoff Atomkonzentration ([H]) wurde mit 2 MeV He ERDA (Elastic Recoil Detection Analysis) für 2 DLC Proben ermittelt: eine mit und eine ohne Gradient. Zur Berechnung der Daten wurde ein Standard mit 9.5 at% H (Glimmer) als Referenz gemessen und der Energieverlust (Bremsvermögen) der Alphateilchen in den DLC-Schichten und im Standard wurde mit den SRIM Programm (www.srim.org) bestimmt. Die Beschichtung der DLC Schicht ohne Gradient erfolgte mit einem konstanten Substratbias von 900 V und nahm 80 Minuten in Anspruch (Schichtdicke ∼ 1 µm). Zur Beschichtung der DLC Schicht mit Gradient wurde der Substratbias kontinuierlich von 900 V auf 50 V reduziert. Dieser Schritt nahm 80 Minuten in Anspruch und resultierte in einer Gradientenschichtdicke von 1.5 µm. Die Resultate sind in Figur 1 dargestellt. Diese Methode erlaubt es, bis in eine Tiefe von etwa 350 nm zu messen. Die Oberfläche ist im Profil rechts (0) und die Tiefenskala läuft nach links. Die Resultate zeigen, dass die Wasserstoffatomkonzentration zu der Gradientenoberfläche hin zunimmt. Bei der DLC Probe ohne Gradient bleibt die Wassserstoffatomkonzentration hingegen konstant.

Die Verschleissbeständigkeit der DLC-Probe mit Gradientenschicht wurde mit einer anwendungsbezogenen Testmethode untersucht, die auf dem Abriebtestgerät "Crockmaster" von James Heal (http://www.james-heal.co.uk/) basiert. In dieser Methode wurde eine beschichtete Probe mit einem 1 cm x 1 cm Schleifpapier (3M281Q Wetordry, mit 9 µm Al2O3 Partikeln) abgerieben. Das Gerät bewegt das Schleifpapier auf der mit tiefchwarzem DLC beschichteten Probe hin und her mit einer Frequenz von 1 Hz. Eine 9N Last ist auf dem Schleifpapier gesetzt und dieses wird nach jeden 500 hin und her Hubzyklen ersetzt. Nach 6000 Hubzyklen waren keine signifikante Änderung der Farbewerte (L*, a* und b*) und keine Kratzspuren feststellbar. Im Vergleich dazu weisen tiefschwarze (L*35) TiAlCN PVD Schichten unter denselben Testbedingungen bereits nach 1000 Hubzykien erheblichen Abrieb auf.

## Patentansprüche

1. Hartstoffschicht auf einer Komponente, wobei die Hartstoffschicht eine DLC-Schicht mit einer Härte von mindestens 10GPa und einem Brechungsindex n_{DLC} von n_{DLC}>2.1 umfasst, **dadurch gekennzeichnet, dass** auf der diamantähnlichen Kohlenstoffschicht eine mindestens 300nm dicke Gradientenschicht vorgesehen ist, welche einen Brechungsindexgradienten aufweist, wobei der über 30nm gemittelte Brechungsindex der Gradientenschicht im Bereich der Grenzfläche zur DLC-Schicht den Wert 2.0 nicht unterschreitet und der über 30nm gemittelte Brechungsindex der Gradientenschicht im Bereich des Übergangs zur Luft den Wert von 1.85 nicht überschreitet und vorzugsweise bei n=1.7 liegt.

2. Hartstoffschicht nach Anspruch 1 **dadurch gekennzeichnet, dass** sich die chemische Zusammensetzung der Gradientenschicht von der chemischen Zusammensetzung der DLC-Schicht im Wesentlichen lediglich im Wasserstoffgehalt unterscheidet.

3. Hartstoffschicht nach einem der vorangehenden Ansprüche, **dadurch gekennzeichnet, dass** der in der Gradientenschicht verwirklichte Brechungsindexgradient ausgehend von der DLC-Schicht in Richtung Oberfläche zu einem monoton kleiner werdenden Brechungsindex führt.

4. Hartstoffschicht nach einem der vorangehenden Ansprüche, **dadurch gekennzeichnet, dass** die Dicke der Gradientenschicht so gewählt wird, dass die Oberfläche tiefschwarz erscheint.

5. Verfahren zur Herstellung einer tiefschwarzen, verschleissfesten Oberfläche umfassend die Schritte:
- Beladung einer Beschichtungskammer mit zu beschichtenden Substraten
- Abpumpen der Beschichtungskammer und Einlassen von Prozessgas umfassend Acetylen und Argon
- Aufbau eines Plasmas vorzugsweise mittels Niedervoltbogenentladung
- Anlegen eines Substratbias an die zu beschichtenden Substrate
**dadurch gekennzeichnet, dass** zur Ablegung einer DLC-Schicht zunächst ein betragsmässig hoher Substratbias angelegt wird und zur anschliessenden Beschichtung einer Gradientenschicht der Substratbias verringert, vorzugsweise kontinuierlich und/oder mit einer Vielzahl von kleinen Reduktionsschritten, wobei die Gradientenschicht so abgeschieden wird, dass sie eine Schichtdicke von mindestens 300 nm und einen Brechungsindexgradienten aufweist, und wobei der über 30nm gemittelte Brechungsindex der Gradientenschicht im Bereich der Grenzfläche zur DLC-Schicht den Wert 2.0 nicht unterschreitet und der über 30 nm gemittelte Brechungsindex der Gradientenschicht im Bereich des Übergangs zur Luft den Wert von 1.85 nicht überschreitet und vorzugsweise bei n=1.7 liegt.

## Claims

1. A hard material layer on a component, wherein the hard material layer comprises a DLC layer with a hardness of at least 10 GPa and a refractive index n_{DLC} of n_{DLC}>2.1, **characterized in that** a gradient layer, which is at least 300 nm thick and has a refractive index gradient, is provided on the diamond-like carbon layer, wherein the refractive index of the gradient layer averaged over 30 nm in the region of the interface with the DLC layer does not drop below 2.0 and the refractive index of the gradient layer averaged over 30 nm in the region of the transition towards the air does not exceed the value of 1.85 and is preferably n=1.7.

2. The hard material layer according to claim 1, **characterized in that** the chemical composition of the gradient layer differs from the chemical composition of the DLC layer substantially only with regard to the hydrogen content.

3. The hard material layer according to any one of the preceding claims, **characterized in that** the refractive index gradient realized in the gradient layer yields a monotonically decreasing refractive index, starting from the DLC layer towards the surface.

4. The hard material layer according to any one of the preceding claims, **characterized in that** the thickness of the gradient layer is selected so that the surface is jet-black in appearance.

5. A method for manufacturing a jet-black wear-resistant surface, comprising the steps of:
- loading a coating chamber with substrates to be coated
- pumping out the coating chamber and introducing a process gas including acetylene and argon
- generating a plasma, preferably by means of low-voltage arc discharge
- applying a substrate bias to the substrates to be coated
**characterized in that**, in order to deposit a DLC layer, first a quantitatively high substrate bias is applied and for the subsequent coating of a gradient layer, the substrate bias is reduced, preferably continuously and/or with a plurality of small reduction steps, wherein the gradient layer is deposited in such a way that it has a layer thickness of at least 300 nm and a refractive index gradient, and wherein the refractive index of the gradient layer averaged over 30 nm in the region of the interface with the DLC layer does not drop below 2.0 and the refractive index of the gradient layer averaged over 30 nm in the region of the transition towards the air does not exceed the value of 1.85 and is preferably n=1.7.

## Revendications

1. Couche en matériau dur sur un composant, la couche en matériau dur comprenant une couche DLC ("Diamant Like Carbon") d'une dureté d'au moins 10 GPa et d'un indice de réfraction n_{DLC} de n_{DLC} > 2,1, **caractérisée en ce que** sur la couche de carbone semblable au diamant est prévue une couche à gradient d'une épaisseur d'au moins 300 nm qui présente un gradient d'indice de réfraction, dans laquelle, dans la zone de la surface limite vers la couche DLC, l'indice de réfraction moyenné sur 30 nm de la couche à gradient ne passe pas au-dessous de la valeur 2,0, et dans la zone de la transition vers l'air, l'indice de réfraction moyenné sur 30 nm de la couche à gradient ne passe pas au-dessus de la valeur 1,85 et est de préférence d'environ n = 1,7.

2. Couche en matériau dur selon la revendication 1, **caractérisée en ce que** la composition chimique de la couche à gradient se distingue de la composition chimique de la couche DLC sensiblement par la seule teneur en hydrogène.

3. Couche en matériau dur selon l'une des revendications précédentes, **caractérisée en ce qu'**en partant de la couche DLC, le gradient d'indice de réfraction réalisé dans la couche à gradient mène à un indice de réfraction qui diminue de façon monotone en direction de la surface.

4. Couche en matériau dur selon l'une des revendications précédentes, **caractérisée en ce que** l'épaisseur de la couche à gradient est choisie de telle sorte que la surface apparaît en noir profond.

5. Procédé de réalisation d'une surface noire profonde résistante à l'usure, comprenant les étapes suivantes consistant à :
- charger une chambre de revêtement avec des substrats à revêtir,
- évacuer la chambre de revêtement et introduire un gaz de processus comprenant de l'acétylène et de l'argon,
- constituer un plasma de préférence au moyen d'une décharge en arc à basse tension,
- appliquer une polarisation aux substrats à revêtir,
**caractérisé en ce que**
pour poser une couche DLC, on applique tout d'abord une polarisation d'une valeur élevée, et pour revêtir ensuite une couche à gradient, on réduit la polarisation, de préférence en continu et/ou avec une multitude de petits pas de réduction, la couche à gradient étant déposée de manière à présenter une épaisseur de couche d'au moins 300 nm et un gradient d'indice de réfraction, et dans la zone de la surface limite vers la couche DLC, l'indice de réfraction moyenné sur 30 nm de la couche à gradient ne passe pas au-dessous de la valeur 2,0, et dans la zone de la transition vers l'air, l'indice de réfraction moyenné sur 30 nm de la couche à gradient ne passe pas au-dessus de la valeur 1,85 et est de préférence d'environ n = 1,7.
